# EUROPEAN PATENT APPLICATION

(11) **EP 4 755 846 A1**
(43) Date of publication of application: **10.06.2026**
(21) Application number: 24885639.5
(22) Date of filing: 28.10.2024
(51) Int. Cl.: C01B 19/00, B82Y 20/00, B82Y 40/00

(54) **SEMICONDUCTOR NANOPARTICLE CONTAINING AGAUTE COMPOUND AS MAIN COMPONENT**

(30) Priority: 31.10.2023 JP 2023186490
(71) Applicant: NATIONAL UNIVERSITY CORPORATION TOKAI NATIONAL HIGHER EDUCATION AND RESEARCH SYSTEM, Nagoya-shi, Aichi 464-8601 (JP); Tanaka Precious Metal Technologies Co., Ltd., Tokyo 103-0025 (JP)
(72) Inventor: TORIMOTO, Tsukasa, Nagoya-shi, Aichi 464-8601 (JP); MIYAMAE, Chie, Nagoya-shi, Aichi 464-8601 (JP); KIKKAWA, Atsushi, Nagoya-shi, Aichi 464-8601 (JP); KAMEYAMA, Tatsuya, Nagoya-shi, Aichi 464-8601 (JP); SATO, Hiroki, Tsukuba-shi, Ibaraki 300-4247 (JP); OHSHIMA, Yuusuke, Tsukuba-shi, Ibaraki 300-4247 (JP); SATO, Taisuke, Tsukuba-shi, Ibaraki 300-4247 (JP); KANASUGI, Takafumi, Tsukuba-shi, Ibaraki 300-4247 (JP)
(74) Representative: Weickmann & Weickmann PartmbB
(86) International application number: PCT/JP2024/038260
(87) International publication number: WO 2025/094866

(57) **Abstract**

The present invention relates to a semiconductor nanoparticle including a AgAuTe compound containing Ag, Au, and Te as essential constituent elements. The AgAuTe compound constituting the semiconductor nanoparticle is represented by the following formula. The present inventive semiconductor nanoparticle includes 90% by atom or more of the AgAuTe compound. present inventive semiconductor nanoparticle is one, which is improved in light absorption characteristics in a long-wavelength region and which can be suitably correspondent in the near infrared region and the short-wave infrared region, and specifically the absorption edge wavelength on the long-wavelength side of the absorption spectrum The present inventive semiconductor nanoparticle is 1200 nm or more.

[Formula 1] AgₓAu_{y}Te_{z}

In the formula, x, y, and z are the respective numbers of Ag, Au, and Te atoms, and 0.25 ≤ z/(x + y) ≤ 1 and y/(x + y + z) > 0.10 are satisfied.

## Description

### FIELD OF THE INVENTION

The present invention relates to a semiconductor nanoparticle containing a AgAuTe compound as a main component, specifically to a semiconductor nanoparticle which has optical semiconductor characteristics and has favorable light absorption characteristics, in particular, in a long-wavelength region.

### DESCRIPTION OF THE RELATED ART

Semiconductors are formed into nanoscale microparticles to exert the quantum confinement effect and exhibit the bandgap depending on the particle size. Therefore, semiconductor nanoparticles can be controlled for the composition and the particle size and regulated for the bandgap to allow the emission wavelength and the absorption wavelength to be arbitrarily set. Semiconductor particles utilizing such characteristics are also referred to as quantum dots (QD), and are expected to be actively used in various technical fields. Application examples of semiconductor nanoparticles are studied about, for example, utilization in light-emitting devices and fluorescent substances for use in display apparatuses, marker substances for bio-related substance detection, and the like.

Semiconductor nanoparticles not only can be controlled for the emission wavelength by particle size adjustment as described above, but also exhibit a sufficiently narrow and stable emission peak width as compared with organic dyes. Furthermore, semiconductor nanoparticles not only can be controlled for the absorption wavelength, but also have the properties of having a high quantum efficiency and a high absorbance index. Semiconductor nanoparticles, because of such characteristics, are also studied about use for photoelectric conversion devices or light-receiving elements to be mounted in solar batteries, various light sensors, or the like.

In particular, semiconductor nanoparticles are expected to be applied in light-receiving elements for light sensors corresponding to the near infrared region (NIR) or the short-wave infrared region (SWIR). These light sensors capable of corresponding to light in the long-wavelength region are mounted in LIDAR (Light Detection and Ranging) or SWIR image sensors. LIDAR is a remote sensing system for automobile automatic operations, drones, marine vessels, and the like, and serves as an important device for development of recent automatic operation techniques. In recent years, LIDAR has also been applied to face authentication techniques or augmented reality (AR) techniques in smartphones, tablets, or the like. SWIR image sensors are devices predicted to be increasingly demanded in future in the fields of food inspection, agriculture, drone, and the like.

Application examples of conventional light-receiving elements for sensors in optical devices as described above have been often Si thin films. However, sensors with Si thin films are significantly deteriorated in sensitivity in a long wavelength region of 900 nm or more, and therefore cannot be suited for the above applications. Thus, development of light-receiving elements with semiconductor nanoparticles is expected.

Some semiconductor compounds have been heretofore studied for constitutions of semiconductor nanoparticles. There are known, as semiconductor compounds having absorption wavelengths in the long-wavelength region of the near infrared region (NIR) and the short-wave infrared region (SWIR), metal chalcogenide compounds such as PbS, PbSe, CdHgTe, Ag₂S, Ag₂Se, Ag₂Te, AgInSe₂, AgInTe₂, CuInSe₂, CuInTe₂, and InAs (Patent Documents 1 to 4). The present applicant also discloses a nanoparticle of a semiconductor compound with a AgAuS-based compound as a main component (Patent Document 5).

### Prior Art Document

### Patent Document

Patent Document 1
   Japanese Patent Application Laid-Open No. 2004-243507
Patent Document 2
   Japanese Patent Application Laid-Open No. 2004-352594
Patent Document 3
   Japanese Patent Application Laid-Open No. 2017-014476
Patent Document 4
   International Publication No. WO2020/054764
Patent Document 5
   Japanese Patent No. 7269591

### SUMMARY OF THE INVENTION

### Technical Problem

Although the above semiconductor compounds have light absorption characteristics in the desired wavelength region, most of such compounds have drawbacks in light of use in applications such as display apparatuses or markers for bio-related substance detection. For example, the RoHS Directive (Restriction of the use of certain Hazardous Substances in electrical and electronic equipment) in EU prescribes use restrictions of Pb in electrical and electronic equipment from the viewpoint of environmental burden. Therefore, a semiconductor nanoparticle including a compound containing Pb as a metal component is hardly expected to be widely utilized in electrical and electronic fields. A compound having Cd, Hg, or the like being a heavy metal is also difficult to utilize in view of use of semiconductor nanoparticles in the bio-related field.

Although the above semiconductor compounds have optical responsivity in a long-wavelength region, one having an absorption wavelength on the longer-wavelength side is increasingly demanded. Recent automobile automatic operation techniques have been remarkably developed, and are required to deal with automatic operation levels (Levels 4 and 5) at which no operation by any driver is premised. In this case, it is important for LIDAR to have responsivity in a longer wavelength region in which there is hardly affected by solar light/natural light. Therefore, it is deemed that quantum dot techniques are still being studied. There is then a need for a semiconductor nanoparticle capable of exhibiting responsivity in a longer wavelength region in consideration of usefulness.

The present invention has been made against the background of the above circumstances, and proposes a semiconductor nanoparticle including a novel semiconductor compound, in which the semiconductor nanoparticle not only is provided in consideration of usefulness against various regulations, but also has suitable optical semiconductor characteristics. The present invention particularly presents a semiconductor nanoparticle which is improved in light absorption characteristics in a long-wavelength region, as compared with conventional ones, and which can be suitably correspondent in the near infrared region (NIR) and the short-wave infrared region (SWIR).

### Solution to Problem

In order to solve the above problems, the present inventors have focused on a AgAuS ternary compound relating to the prior art (Patent Document 5) by the present applicants. Ag and Au are suitably usable metals from the viewpoint of corresponding to regulations on environmental burden, toxicity, and the like, and AgAuS compounds are semiconductor compounds capable of exhibiting optical semiconductor characteristics. However, AgAuS compounds have an absorption wavelength on the slightly-low-wavelength side, and have the remaining problem about optical responsivity in the infrared region (NIR) and the short-wave infrared region (SWIR). In this regard, the prior art by the present applicant provides a AgAuS-based multinary compound by addition of a metal such as In to a AgAuS compound and thus allows the absorption wavelength to be shifted toward a longer wavelength.

The present inventors have conceived application of a Te (tellurium) element which is a chalcogen element larger in mass than S (sulfur), as a chalcogen element of a semiconductor compound, against the prior art. The reason for this is that application of a chalcogen element larger in mass than S is presumed to result in a decrease in orbital energy difference between each metal element and the chalcogen element during formation of the compound, thereby allowing optical responsivity to be shifted toward a longer wavelength. The present inventors have then studied nanoparticle formation from a AgAuTe compound as a chalcogen compound of Ag and Au and optical characteristics of such a nanoparticle.

It has been confirmed from these studies by the present inventors that a nanoparticle with a AgAuTe compound as a main component exhibits an absorption wavelength in a long-wavelength region as compared with a AgAuS compound and a AgAuSe compound with Se as a chalcogen element. The AgAuTe compound studied by the present inventors can be formed into a stable nanoparticle having relatively high crystallinity. However, the AgAuTe compound has been confirmed to affect dispersibility of such a nanoparticle depending on the composition, in particular, the content of Au. The present inventors have found a semiconductor nanoparticle including a AgAuTe compound having a suitable composition, based on these study results, and have conceived the present invention.

Specifically, the present invention solving the above problems is drawn to a semiconductor nanoparticle including a AgAuTe compound containing Ag, Au, and Te as essential constituent elements, represented by the following formula, wherein the semiconductor nanoparticle includes 90% by atom or more of the AgAuTe compound.

[Formula 1] AgₓAu_{y}Te_{z}

wherein x, y, and z are the respective numbers of Ag, Au, and Te atoms, and 0.25 ≤ z/(x + y) ≤ 1 and y/(x + y + z) > 0.10 are satisfied.

Hereinafter, a constitution and a production method of the semiconductor nanoparticle containing an AgAuTe compound as a main component of the present invention are described in detail.

### A. Constitution of the semiconductor nanoparticle of the present invention

### A-1. Chemical composition of semiconductor nanoparticle

As described above, the semiconductor nanoparticle of the present invention includes a AgAuTe compound as a main component (90% by mass or more). Accordingly, Ag and Au are essential elements as metal elements (transition metal elements) constituting the AgAuTe compound. Te is a chalcogen element essential for and characteristic of the present invention. As described above, Te is an element large in mass among chalcogen elements such as S and Se. Te is applied to allow responsivity effective in both the near infrared region (NIR) and the short-wave infrared region (SWIR) to be exhibited.

The AgAuTe compound constituting the semiconductor nanoparticle of the present invention can be represented by AgₓAu_{y}Te_{z} where the respective numbers of Ag, Au, and Te atoms are designated as x, y, and z. In view of the composition of the AgAuTe compound, the value of y/(x + y + z) as the proportion of the number of Au atoms in the compound satisfies y/(x + y + z) > 0.10. Specifically, the content of Au in the AgAuTe compound in the present invention is more than 10% by atom, and a AgAuTe compound having a content of Au of 10% by atom or less is excluded from the present invention. Although the detail of the reason why a content of Au 10% by atom or less is excluded is not clear, it has been confirmed from studies by the present inventors that a nanoparticle of a AgAuTe compound low in content of Au is easily aggregated and is inferior in dispersibility. The proportion of the number of Au atoms, y/(x + y + z), is preferably 0.11 or more, more preferably 0.12 or more.

The upper limit of the proportion of the number of Au atoms, y/(x + y + z), is preferably 0.35 or less, more preferably 0.20 or less because such a range allows a stable AgAuTe compound favorable in crystallinity to be provided.

Te is contained in the AgAuTe compound so that charge compensation is made for Ag and Au. The number z of Te atoms in the AgAuTe compound satisfies 0.25 ≤ z/(x + y) ≤ 1. The number z of Te atoms more preferably satisfies 0.3 ≤ z/(x + y + z) ≤ 0.7, further preferably 0.3 ≤ z/(x + y + z) ≤ 0.5, particularly preferably 0.3 ≤ z/(x + y + z) ≤ 0.4.

The proportion of Ag in the AgAuTe compound in the present invention corresponds to the balance of the above proportions of Au and Te. The value of x/(x + y + z), as the proportion of the number of Ag atoms, is preferably 0.3 or more and 0.6 or less.

The composition of the AgAuTe compound, described above, is the entire composition of the AgAuTe compound in the semiconductor nanoparticle. The AgAuTe compound applied to the present invention may be constituted of a single phase or a plurality of phases. Examples of a specific possible chemical composition of the AgAuTe compound (AgₓAu_{y}Te_{z}) include some compositions depending on the valences of Ag, Au, and Te, and a compound having a stoichiometric composition such as Ag₃AuTe₂ (x = 3, y = 1, z = 2) or AgAuTe₂ (x = 1, y = 1, z = 2) can be synthesized. The AgAuTe compound in the semiconductor nanoparticle of the present invention is constituted in the form of a single phase or a plurality of phases of a compound having such a stoichiometric composition. A compound not having the above stoichiometric composition may also be contained, provided that x, y, and z in the entire AgAuTe compound in the semiconductor nanoparticle fall within the respective ranges. Herein, the AgAuTe compound constituting the semiconductor nanoparticle of the present invention often has high crystallinity and contains a compound having the above stoichiometric composition.

The semiconductor nanoparticle of the present invention contains the AgAuTe compound as a main component, and is constituted of 90% by atom or more of the AgAuTe compound. The semiconductor nanoparticle may include only the AgAuTe compound. The semiconductor nanoparticle more preferably includes 95% by atom or more of the AgAuTe compound. The semiconductor nanoparticle of the present invention sometimes includes any other element than the AgAuTe compound (Ag, Au, and Te). For example, the semiconductor nanoparticle sometimes includes a constituent element of a solvent and/or an element contained in each precursor substance of Ag, Au, and Te serving as raw materials in synthesis of the AgAuTe compound. Examples of the element which can be contained, other than Ag, Au, and Te as essential constituent elements, include C, P, S, Se, Cl, Br, and I, and the content of these elements in the semiconductor nanoparticle is acceptable as long as the content is less than 10% by mass. It is noted that the composition values of the compound and elements shown here are values with respect to the semiconductor nanoparticle and the contents of a protective agent described below and a constituent element of the protective agent are not included.

### A-2. Structure of the semiconductor nanoparticle of the present invention

As described above, the AgAuTe compound applied to the present invention is constituted of a single phase or a plurality of phases. A mode of a semiconductor nanoparticle including a plurality of phases can have a so-called core-shell structure. An example of the core-shell structure is a structure where the AgAuTe compound containing Ag, Au, and Te serves as a core (core compound) and a compound different in composition from the core compound or a compound not containing any of Ag, Au, and Te serves as a shell (shell compound) and covers at least one portion of a surface of the core compound. A specific example considered here is a semiconductor nanoparticle constituted of a core compound including a Au-rich AgAuTe compound and a shell compound including a Ag- and Te-rich AgAuTe compound covering at least one portion of a surface of the core compound. Herein, the "Au-rich" means that the compositional ratio of Au in the compound is 50% by atom or more, and the "Ag- and Te-rich" means that the total compositional ratio of Ag and Te in the compound is 50% by atom or more. The structure of the semiconductor nanoparticle is not limited to a regular combination of a plurality of phases, like the above core-shell structure, and may be a structure of a plurality of phases different in composition randomly distributed.

The shape of the semiconductor nanoparticle of the present invention may be a spherical shape, or a cube shape or a rod shape. A spherical-shaped or cube-shaped semiconductor nanoparticle preferably has an average particle size of 2 nm or more and 20 nm or less. The particle size of the semiconductor nanoparticle is associated with the adjustment action of the bandgap with the quantum confinement effect. The above average particle size is preferred for exertion of suitable light absorption characteristics with bandgap adjustment. The average particle size of the semiconductor nanoparticle can be here obtained with observation of a plurality of (preferably 100 or more) particles with an electronic microscope such as TEM, measurement of the particle size of each particle, and calculation of the particle number average. The particle size can be here measured as the average value of the longer size (longer axis) and the shorter size (shorter axis).

A scanning transmission electron microscope (Scanning TEM) can be here suitably used in analysis of the composition and the structure of the semiconductor nanoparticle of the present invention. In particular, a high angle annular dark field scanning TEM (HAADF-STEM) can provide a scattered image reflecting the composition information of the nanoparticle, and can be combined with an energy dispersive X-ray spectrometer (EDX) or the like, to figure out the distribution state of Ag, Au, and Te, and the composition of the entire nanoparticle.

### A-3. Optical semiconductor characteristics of the semiconductor nanoparticle of the present invention

As described above, the semiconductor nanoparticle is adjusted with respect to the bandgap with the quantum confinement effect depending on the particle size, and varied in light absorption characteristics. The absorption edge wavelength on the long-wavelength side of the absorption spectrum of the semiconductor nanoparticle of the present invention is preferably 1200 nm or more. Thus, the semiconductor nanoparticle has absorptivity and responsivity to light in the visible region to the near-infrared region. A more preferred aspect of the present invention can be drawn to a semiconductor nanoparticle in which the absorption edge wavelength on the long-wavelength side of the absorption spectrum is 1300 nm or more.

### A-4. Usage aspect of the semiconductor nanoparticle of the present invention

The semiconductor nanoparticle of the present invention, which is applied to and supported on an appropriate substrate or carrier, can be thus applied in various applications described above, such as a light sensor device. The constitutions, shapes and dimensions of such substrate or carrier are not particularly limited. Examples of a plate-, foil- or film-like substrate include glass, quartz, silicon, ceramics or metal. Examples of a particulate or powdery carrier include inorganic oxides such as ZnO, TiO₂, WO₃, SnO₂, In₂O₃, and Al₂O₃. The semiconductor nanoparticle may be supported on the inorganic oxide carrier and furthermore fixed to the substrate.

When the semiconductor nanoparticle is applied to and supported on the substrate or carrier, a solution or slurry or ink in which the semiconductor nanoparticle is dispersed in an appropriate dispersion medium is often used as described above. The dispersion medium usable in the solution or the like is chloroform, toluene, cyclohexane, hexane, or the like. A usable application method of the solution or the like of the semiconductor nanoparticle can be dipping or a spin coating method, and a usable supporting method of the semiconductor nanoparticle can be any of various methods such as a dropping method, an impregnation method, and an adsorption method.

The semiconductor nanoparticle of the present invention preferably includes a protective agent for suppressing aggregation during the synthesis of the semiconductor nanoparticle or in dispersing of the semiconductor nanoparticle in the dispersion medium as described above. The protective agent is preferably at least any one of an alkylamine having 4 or more and 20 or less alkyl chain carbon atoms, an alkenylamine having 4 or more and 20 or less alkenyl chain carbon atoms, an alkylcarboxylic acid having 3 or more and 20 or less alkyl chain carbon atoms, an alkenylcarboxylic acid having 3 or more and 20 or less alkenyl chain carbon atoms, and an alkanethiol having 4 or more and 20 or less alkyl chain carbon atoms. Such a protective agent is bound to a surface of the semiconductor nanoparticle to cover at least one portion of the surface, and inhibit the semiconductor nanoparticle from being aggregated in a dispersion liquid, thereby providing a homogeneous solution or the like. Such a protective agent is added together with a raw material, to the reaction system, to synthesize a nanoparticle having a suitable average particle size in a synthesis process of the semiconductor nanoparticle. Such a protective agent can be applied in a single form of the above alkylamine, alkenylamine, alkylcarboxylic acid, alkenylcarboxylic acid, and alkanethiol, or as a combination of a plurality of these protective agents.

### B. Method for producing the semiconductor nanoparticle of the present invention

Next, the method for producing the semiconductor nanoparticle of the present invention is described.

As described above, the present invention is drawn to a semiconductor nanoparticle with, as a main component, a AgAuTe compound in which Ag₂Te is doped with Au. It is considered based on this conception that the semiconductor nanoparticle (AgₓAu_{y}Te_{z}) of the present invention can be produced with Au added to a nanoparticle of Ag₂Te. However, the AgAuTe compound applied in the present invention is required to contain more than 10% by atom of Au (y/(x + y + z) > 0.10). Studies by the present inventors indicate that a compound satisfying the above condition of the content of Au is difficult to synthesize by a method including adding Au to a Ag₂Te nanoparticle.

The present inventors have found that the synthesis of a AgAuTe compound having an optimized content of Au requires synthesis where respective compounds of Ag, Au, and Te as constituent elements are used as precursors (Ag precursor, Au precursor, and Te precursor) and these compounds are introduced into the same reaction system and simultaneously heated and thus reacted. Hereinafter, the method for producing the semiconductor nanoparticle, to which the method for synthesizing the AgAuTe compound is applied, is described.

### B-1. Raw materials (Ag precursor, Au precursor, and Te precursor)

The Ag precursor, the Au precursor, and the Te precursor applied as raw materials are a Ag salt or a Ag complex, and a Au salt or a Au complex, respectively. The Ag precursor and the Au precursor are preferably a salt or complex containing monovalent Ag and one containing monovalent Au.

The Ag precursor applied is a Ag salt or a Ag complex. The Ag precursor is preferably a salt or complex containing monovalent Ag. Specific suitable examples of the Ag precursor include silver acetate (Ag(OAc)), silver nitrate, silver carbonate, silver oxide, silver oxalate, silver chloride, silver iodide, silver(I) cyanide, and silver diethyldithiocarbamate.

The Au precursor applied is a Au salt or a Au complex. The Au precursor is preferably a salt or complex containing monovalent Ag. Here, the Au precursor used can also be a salt or complex containing trivalent Au. This is because trivalent Au is reduced to monovalent Au with the solvent, the coexisting Te precursor, or the like, during synthesis of the semiconductor nanoparticle. Specific suitable examples of the Au precursor include chloro(dimethylsulfide)gold(I) ((CH₃)₂SAuCl), Au resinate (C₁₀H₁₈Au₂S₂: CAS68990-27-2), gold(I) iodide, gold(I) sulphite, chlorauric acid(III), gold(III) acetate, gold(I) cyanide, gold(III) cyanide, and 1,10-phenanthroline gold(III).

The Te compound applicable as the Te precursor can be a Te compound such as tellurium oxide (TeO₂), telluric acid (Te(OH)₆), or sodium tellurite (Na₂TeO₃).

### B-2. Formation of reaction system of AgAuTe compound

The AgAuTe compound is synthesized with one reaction system formed from the above Ag precursor, the Au precursor, and the Te precursor mixed. The Ag precursor, the Au precursor, and the Te precursor separately prepared may be here sequentially mixed. The order of mixing here is not particularly limited. The reaction system may also be formed by adjustment of a mixture of the Ag precursor and the Au precursor serving as metal components of the AgAuTe compound, as a metal source precursor, and then mixing of the metal source precursor and the Te precursor.

The proportions (x, y, z) of the numbers of atoms of the respective elements in the AgAuTe compound (AgₓAu_{y}Te_{z}) synthesized can be adjusted with the ratio of the amounts of the Ag precursor and the Au precursor loaded. The ratio of the amounts of the respective precursors loaded for the purpose of a suitable AgAuTe compound obtained is preferably set to 1.0 or more and 6.0 or less, more preferably 2.0 or more and 5.0 or less, in terms of the ratio (a/b: hereinafter, sometimes referred to as "ratio of Ag loaded") under the assumption that the number of Ag atoms in the Ag precursor is a and the number of Au atoms in the Au precursor is b.

The amount of the Te precursor loaded in the reaction system can be set in a relatively wide range relative to the amounts of Ag and Au loaded, described above. The reason is because, even if excess Te is present in the reaction system, the Te precursor has a small effect on the composition of the AgAuTe compound.

As described above, a protective agent is preferably bound to the AgAuTe compound in the semiconductor nanoparticle of the present invention. Therefore, a protective agent is preferably added together with the Ag precursor, the Au precursor, and the like, to the above reaction system. A preferred protective agent added here is at least any one of an alkylamine having 4 or more and 20 or less alkyl chain carbon atoms, an alkenylamine having 4 or more and 20 or less alkenyl chain carbon atoms, an alkylcarboxylic acid having 3 or more and 20 or less alkyl chain carbon atoms, an alkenylcarboxylic acid having 3 or more and 20 or less alkenyl chain carbon atoms, and an alkanethiol having 4 or more and 20 or less alkyl chain carbon atoms.

The reaction system in synthesis of the semiconductor nanoparticle can also provide a nanoparticle in no solvent, but a solvent is preferably used. When the solvent is used, for example, octadecene, tetradecane, oleic acid, oleylamine, dodecanethiol, or any mixture of these solvents can be applied.

### B-3. Synthesis conditions of AgAuTe compound

A reaction system constituted of the Ag precursor, the Au precursor, the Te precursor, and the protective agent is heated to synthesize a AgAuTe compound nanoparticle. The heating temperature (reaction temperature) is here set to 40°C or more and 200°C or less. A heating temperature of less than 40°C hardly allows a synthesis reaction to progress. In this regard, a heating temperature exceeding 200°C has the problem of sometimes providing a nanoparticle singly formed with Au and leading to no production of any compound having a desired composition. The average particle size of the semiconductor nanoparticle, although increases along with increase of the reaction temperature, less exceeds a suitable average particle size as long as the reaction temperature falls within the above temperature range. A more suitable reaction temperature is 50°C or more and 100°C or less.

The reaction time (heating time) can be adjusted with the amounts of raw materials loaded, and is preferably set to 5 minutes or more and 120 minutes or less. The reaction time is more preferably 10 minutes or more, further preferably 15 minutes or more. The reaction system is here preferably stirred during synthesis reaction of the semiconductor nanoparticle.

After completion of the synthesis reaction of the semiconductor nanoparticle, the reaction system is, if necessary, cooled to recover the semiconductor nanoparticle. The semiconductor nanoparticle may be here precipitated with addition of an alcohol (ethanol, methanol, or the like) serving as a non-solvent or by centrifugation or the like and thus recovered, and furthermore washed with alcohol (ethanol, methanol, or the like) once and then uniformly dispersed in a good solvent such as chloroform.

### Advantageous Effects of the Invention

As described above, the present invention is drawn to a novel semiconductor nanoparticle mainly constituted of a AgAuTe compound. The semiconductor nanoparticle of the present invention has suitable optical semiconductor characteristics, and also has usefulness in consideration of use restrictions or the like. Optical response characteristics of the semiconductor nanoparticle of the present invention can correspond to the long-wavelength region including the near infrared region (NIR) and the short-wave infrared region (SWIR).

### BRIEF DESCRIPTION OF THE DRAWINGS

Fig. 1 shows TEM images of respective semiconductor nanoparticles of Example 1 (AgAuTe), Reference Example 1 (AgAuS), and Reference Example 2 (AgAuSe), synthesized in First Embodiment;
Fig. 2 illustrates measurement results of absorption spectra of respective semiconductor nanoparticles of Example 1 (AgAuTe), Reference Example 1 (AgAuS), and Reference Example 2 (AgAuSe) synthesized in First Embodiment;
Fig. 3 shows TEM images of AgAuTe semiconductor nanoparticles synthesized at the ratio of Ag loaded adjusted in Second Embodiment;
Fig. 4 illustrates XRD diffraction patterns of AgAuTe semiconductor nanoparticles synthesized at the ratio of Ag loaded adjusted in Second Embodiment;
Fig. 5 illustrates measurement results of absorption spectra of AgAuTe semiconductor nanoparticles synthesized at the ratio of Ag loaded adjusted in Second Embodiment;
Fig. 6 shows TEM images of AgAuTe semiconductor nanoparticles synthesized at the reaction temperature adjusted in Third Embodiment;
Fig. 7 illustrates XRD diffraction patterns of AgAuTe semiconductor nanoparticles synthesized at the reaction temperature adjusted in Third Embodiment; and
Fig. 8 illustrates measurement results of absorption spectra of AgAuTe semiconductor nanoparticles synthesized at the reaction temperature adjusted in Third Embodiment.

### DETAILED DESCRIPTION OF THE PREFERRED EMBODIMENTS

First Embodiment: Hereinafter, Embodiments of the present invention are described. In the present Embodiment, each semiconductor nanoparticle including a AgAuTe compound was synthesized, and confirmed with respect to the appearance and the crystal structure of such each semiconductor nanoparticle. An absorption spectrum was measured, and the absorption wavelength was confirmed. Respective semiconductor nanoparticles of a AgAuS compound (Reference Example 1) and a AgAuSe compound (Reference Example 2) for comparison with the AgAuTe compound (Example 1) were synthesized, and comparison with the absorption wavelengths of these compounds for comparison was made.

Example 1: A AgAuTe compound nanoparticle in the present Embodiment was synthesized as a semiconductor nanoparticle by preliminary adjustment of a mixture of a Ag precursor and a Au precursor serving as metal components, as a metal source precursor, in advance, and then mixing/reacting of the metal source precursor with a Te precursor.

In 3.0 mL of oleylamine (OLA) as a solvent were dissolved/mixed 0.3 mmol of silver acetate (Ag(OAc)) as the Ag precursor and a methanol solution of 0.1 mmol of chloro(dimethylsulfide)gold (AuS(CH₃)₂Cl) as the Au precursor. Methanol was removed under reduced pressure, and thus a metal source precursor solution was adjusted (ratio of Ag loaded = 3). On the other hand, 0.2 mmol of tellurium oxide (TeO₂) was dissolved in 0.5 mL of 1-dodecanethiol (DDT) as a solvent/protective agent, and heated under a nitrogen atmosphere at 100°C for 5 minutes, to adjust a Te precursor solution.

The metal source precursor solution was injected into the Te precursor solution with a syringe, and stirred under heating at a reaction temperature of 100°C for 15 minutes. After completion of the reaction, the mixture was allowed to cool for 10 minutes and then centrifuged at 4000 rpm for 5 minutes to separate a supernatant solution and a precipitate. Then, 4 cm³ of ethanol was added as a poor solvent to the supernatant solution to generate a precipitate, and the precipitate was recovered with centrifugation at 4000 rpm for 5 minutes to provide a AgAuTe compound nanoparticle.

The AgAuTe compound nanoparticle obtained with the above operations was dispersed in 3 cm³ of chloroform to give a dispersion liquid of the AgAuSeln semiconductor nanoparticle. This dispersion liquid was transferred to a sample bottle, subjected to purging with nitrogen, thereafter protected from light, and refrigerated and stored.

Reference Example 1: A AgAuS compound nanoparticle with S applied as a chalcogen element forming a compound with Ag and Au was synthesized as follows.

A test tube was loaded with 0.3 mmol of silver acetate as a Ag precursor, 0.1 mmol of chloro(dimethylsulfide)gold(I) as a Au precursor and 0.2 mmol of thiourea as a S precursor, and 2.9 mL of oleylamine as a solvent and 0.1 mL of 1-dodecanethiol as a protective agent were added to the test tube.

After purging with nitrogen in the same manner as above, the mixture was stirred under heating with a hot stirrer at a reaction temperature of 150°C for 10 minutes. After completion of the reaction, the mixture was allowed to cool for 30 minutes and then centrifuged at 4000 rpm for 5 minutes to separate a supernatant solution and a precipitate. A dispersion liquid of the AgAuS compound nanoparticle was obtained with further centrifugation and purification.

Reference Example 2: A AgAuSe compound nanoparticle with Se applied as a chalcogen element forming a compound with Ag and Au was synthesized as follows.

A test tube was loaded with 0.075 mmol of silver acetate (Ag(OAc)) as a Ag precursor, 0.025 mmol of chloro(dimethylsulfide)gold(I) as a Au precursor, and 0.20 mmol of selenourea as a Se precursor. Into the mixture, 2.9 mL of oleylamine (OLA) as a solvent and 0.1 mL of 1-dodecanethiol (DDT) as a protective agent were added.

A stir bar was placed in the test tube loaded with the above raw materials and solvent, which was purged with nitrogen three times, and thereafter the mixture was stirred under heating with a hot stirrer at a reaction temperature of 50°C for 10 minutes. After completion of the reaction, the mixture was allowed to cool for 20 minutes and then transferred to a small test tube, and centrifuged at 4000 rpm for 5 minutes to separate a supernatant solution and a precipitate.

Thereafter, 4 cm³ of methanol was added as a poor solvent to the supernatant solution to generate a precipitate, and the precipitate was recovered with centrifugation at 4000 rpm for 5 minutes. After this precipitate was dispersed in 4 cm³ of ethanol further added, centrifugation was performed under the same conditions to remove a by-product and the solvent and thus purify a AgAuSe compound nanoparticle. A dispersion liquid of the AgAuS compound nanoparticle was obtained with further centrifugation and purification.

### [TEM observation and average particle size measurement]

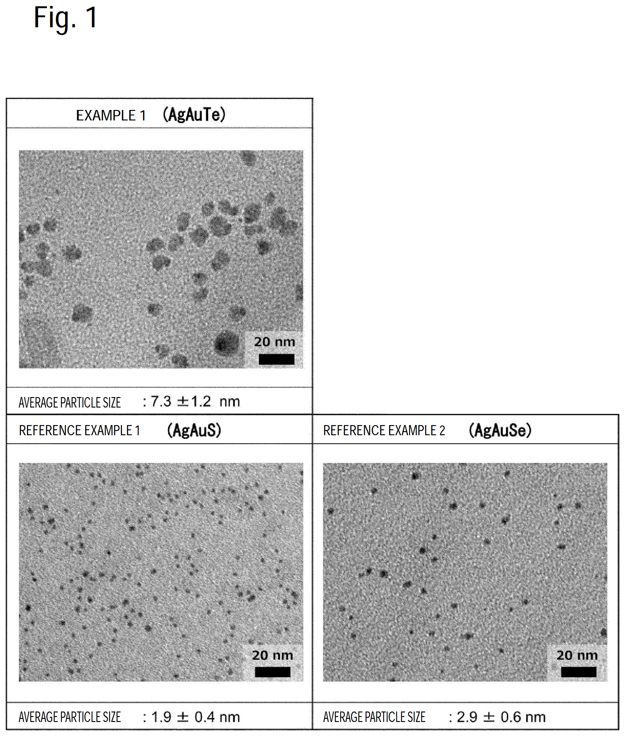

Each of the semiconductor nanoparticles in Example 1 (AgAuTe), Reference Example 1 (AgAuS) and Reference Example 2 (AgAuSe) was observed with TEM. Fig. 1 illustrates TEM images of the produced semiconductor nanoparticles (see scale bars in each of the mages, with respect to the magnifications). It was confirmed from each of the TEM images that substantially spherical nanoparticles were synthesized. The average particle size with respect to the nanoparticles having respective compositions was measured and calculated based on the TEM images. Particle size measurement determined the particle sizes of all measurable nanoparticles included in the TEM images, and calculated the average particle size.

### [Compositional analysis of semiconductor nanoparticle]

Compositional analysis of each of the nanoparticles was carried out by the above TEM observation and also EDX analysis performed. Table 1 shows the measurement results of the compositions of the respective semiconductor nanoparticles. The compositional analysis results are expressed with "% by atom" relative to the entire nanoparticle in the present Embodiment and each Embodiment below. Table 1 also shows the ratio (y/(x + y + z)) of the number (y) of Au atoms based on the total of the number (x) of Ag atoms, the number (y) of Au atoms, and the number (z) of atoms of the chalcogen element (Te, S, and Se), as calculated based on the compositional analysis results.

**[Table 1]**

| | Constitution of nanoparticle | Composition (% by atom) | | | | | y/(x + y + z) |
|---|---|---|---|---|---|---|---|
| | | Ag | Au | Te | S | Se | |
| Example 1 | AgAuTe | 49.6 | 11.6 | 38.8 | - | - | 0.116 |
| Reference Example 1 | AgAuS | 47.8 | 12.3 | - | 39.9 | - | 0.123 |
| Reference Example 2 | AgAuSe | 57.8 | 17.4 | - | - | 24.8 | 0.174 |

| | | | | | | | |
|---|---|---|---|---|---|---|---|
| * Total content of Ag, Au, and chalcogen element (Te, S, Se) in compound constituting nanoparticle was 100%. | | | | | | | |

### [Measurement of absorption spectrum]

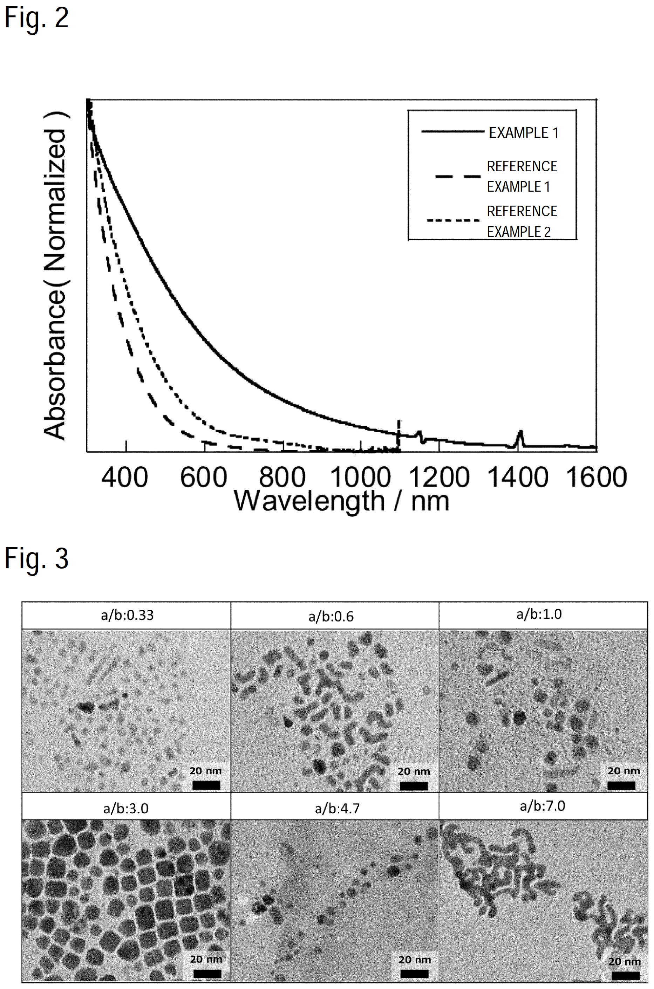

Next, an absorption spectrum was measured with respect to each of the semiconductor nanoparticles in Example 1 (AgAuTe), Reference Example 1 (AgAuSe) and Reference Example 2 (AgAuS). The absorption spectrum was measured in a wavelength range of 400 nm to 1600 nm with an ultraviolet visible spectrophotometer (manufactured by Agilent Technologies, Agilent 8453). Shown in Fig. 2 are measurement results of absorption spectra of the respective semiconductor nanoparticles produced in the present Embodiment.

Referring to Fig. 2, it can be seen that the absorption edge wavelength of the semiconductor nanoparticle in Example 1 (AgAuTe), with Te applied as a chalcogen element, is located on the long-wavelength side as compared with the absorption edge wavelengths of the semiconductor nanoparticles in Reference Example 1 (AgAuS) and Reference Example 1 (AgAuSe), with S and Se as respective chalcogen elements. The absorption edge wavelengths of the respective semiconductor nanoparticles were 1400 nm in Example 1 (AgAuTe), 750 nm in Reference Example 1 (AgAuS), and 950 nm in Reference Example 2 (AgAuSe). The AgAuTe semiconductor nanoparticle with Te large in mass, applied as a chalcogen element, was confirmed to have suitable optical response characteristics in the long-wavelength region.

Second Embodiment: In the present Embodiment, AgAuTe semiconductor nanoparticles of various compositions were each synthesized at the ratio of Ag and Au loaded adjusted. In the present Embodiment, chlorauric acid (HAuCl₄) was applied as the Au precursor to prepare a metal source precursor. Here, the total amount of the metal source precursor was set to a constant amount, the ratio of Ag loaded (Ag/Au: (a/b)) in the total amount was set to 0.33, 1.0, 3.0, 4.7, or 7.0, and the content of Te (the number of moles of the Te precursor loaded) was set to a constant content (0.2 mmol) to synthesize each AgAuTe semiconductor nanoparticle. Synthesis conditions of such each semiconductor nanoparticle were the same as those in First Embodiment except for the Au precursor and the ratio of Ag loaded.

TEM observation and EDX analysis were performed in the same manner as in First Embodiment. Fig. 3 illustrates TEM analysis images of the AgAuTe semiconductor nanoparticles synthesized in the present Embodiment. Table 2 shows compositional analysis results with EDX analysis.

**[Table 2]**

| Ratio of Ag loaded (a/b) | Amount loaded (mmol) | | | Composition (% by atom) | | | y/(x + y + z) | z/(x + y + z) |
|---|---|---|---|---|---|---|---|---|
| | Ag(OAc) | HAuCl₄ | TeO₂ | Ag | Au | Te | | |
| 0.33 | 0.1 | 0.3 | | 60.4 | 0.0 | 39.6 | 0.00 | 0.396 |
| 1.0 | 0.2 | 0.2 | | 34.8 | 30.5 | 34.7 | 0.305 | 0.347 |
| 3.0 | 0.3 | 0.1 | 0.2 | 49.3 | 15.6 | 35.1 | 0.156 | 0.351 |
| 4.7 | 0.33 | 0.07 | | 53.3 | 10.7 | 36.1 | 0.107 | 0.361 |
| 7.0 | 0.35 | 0.05 | | 56.3 | 7.3 | 36.4 | 0.073 | 0.364 |

| | | | | | | | | |
|---|---|---|---|---|---|---|---|---|
| * Total content of Ag, Au, and Te in compound constituting nanoparticle was 100%. | | | | | | | | |

In the present Embodiment, solid particle synthesis can be basically confirmed at any ratio loaded. However, referring to Fig. 3, any nanoparticle at a ratio of Ag loaded of 7.0 was extremely high in aggregability, and had a difficulty in keeping an independent particle state. Such nanoparticles were those in which the proportions of the numbers of Au atoms (y/(x + y + z)) were respectively 0.07, and 0.1 or less. The nanoparticles at ratios of Ag loaded of 7.0, 4.7, 3.0, and 1.0 are liable to be increased in ratio of the number of Au atoms (y/(x + y + z)), as the ratio of Ag loaded is lower.

In this regard, a nanoparticle at a ratio of Ag loaded of 0.33 includes almost no Au and is substantially in the form of a AgTe compound. The reason why Au is not included in a nanoparticle in which the amount of Au loaded is large, although not clear, is considered by the present inventors, as follows. In other words, during synthesis, a Au ion (trivalent) serving as a raw material reacts with an organic component in the system to partially generate a particle of reduced Au (zero-valent). This Au particle is separated from objective AgAuTe and removed with centrifugation after the synthesis reaction. When the Ag ion is present at a large number, the Au ion is consumed for AgAuTe particle production, but when the concentration of the Ag ion is low, the reduction reaction of Au is precedent. It is considered that, if a zero-valent Au particle is present at a large number in the reaction solution, reduction of the Au ion due to the self-catalyst reaction of the Au particle sequentially progresses, resulting in decrease of Au used for AuAgTe particle formation and thus causing formation of a nanoparticle not containing Au.

### [Confirmation of crystallinity of AgAuTe nanoparticle]

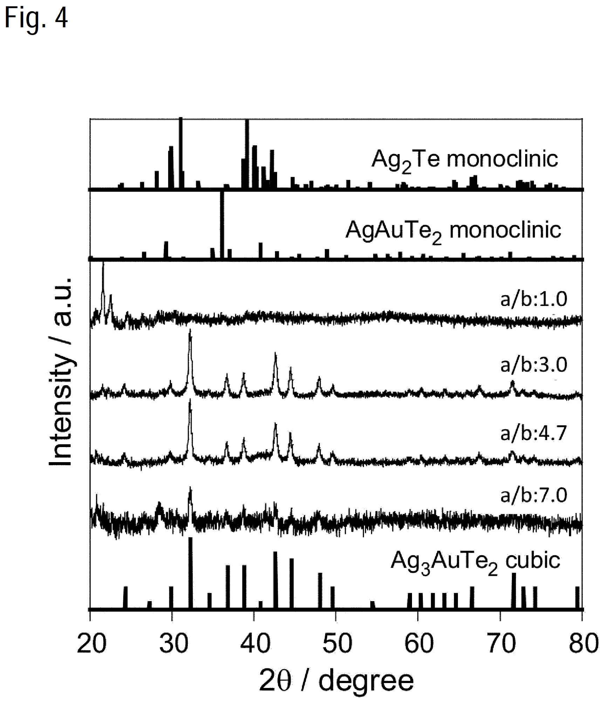

Next, the AgAuTe nanoparticles synthesized in the present Embodiment were subjected to XRD analysis to confirm crystallinity. The XRD analysis apparatus was Smart-Lab-3K manufactured by Rigaku Corporation, the characteristic X-ray was a CuKα ray, and the analysis condition included 1°/min. Fig. 4 illustrates XRD diffraction patterns of samples produced at ratios of Ag loaded of 7.0, 4.7, 3.0, and 1.0, among the AgAuTe nanoparticles in the present Embodiment.

With reference to Fig. 4, the diffraction patterns of the samples at ratios of Ag loaded of 7.0, 4.7, and 3.0, among the AgAuTe nanoparticles synthesized in the present Embodiment, are each favorably matched with a profile of Ag₃AuTe₂. The diffraction peaks of these AgAuTe nanoparticles were sharp and also narrow in full-width at half maximum, and in particular, the nanoparticles at ratios of Ag loaded of 4.7 and 3.0 exhibited particularly favorable crystallinity. It is considered from these results that a suitable AgAuTe nanoparticle is required to have a proportion of the number of Au atoms (y/(x + y + z)) of more than 0.1.

No clear peak was obtained with respect to the sample at a ratio of Ag loaded of 1.0. The reason for this is considered because the AgAuTe nanoparticle of this sample is a particle including a crystallite having a size of several nanometers or less, or an amorphous particle.

### [Absorption spectrum measurement]

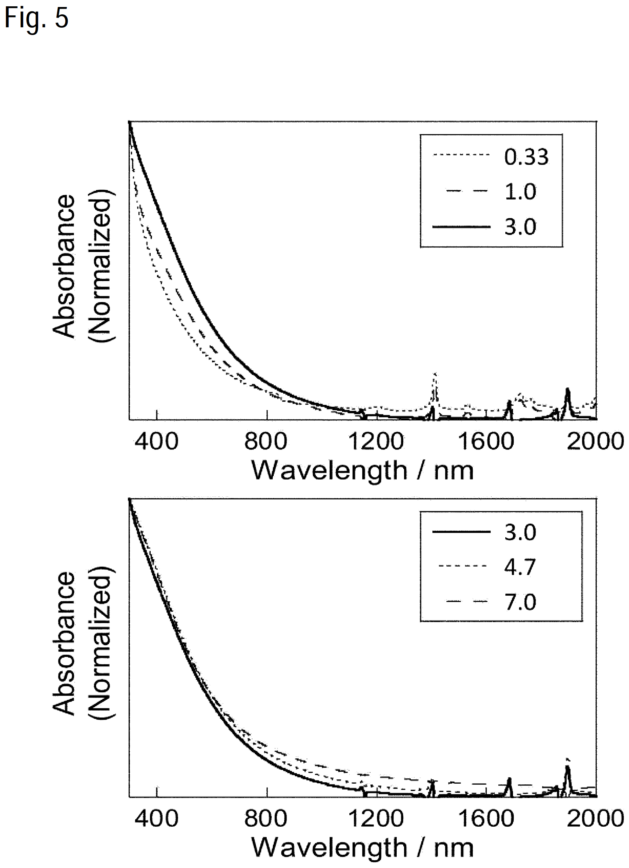

An absorption spectrum of each of the AgAuTe nanoparticles synthesized in the present Embodiment was measured. The method for measuring the absorption spectrum is the same as in First Embodiment. Fig. 5 illustrates the measurement results. Table 3 shows the values of absorption edge wavelengths, calculated from the measurement results.

**[Table 3]**

| Ratio of Ag loaded (a/b) | Composition (% by atom) | | | y/(x + y + z) | Absorption edge wavelength |
|---|---|---|---|---|---|
| | Ag | Au | Te | | |
| 0.33 | 60.4 | 0.0 | 39.6 | 0.00 | 1100 nm |
| 1.0 | 34.8 | 30.5 | 34.7 | 0.31 | 1320 nm |
| 3.0 | 49.3 | 15.6 | 35.1 | 0.16 | 1400 nm |
| 4.7 | 53.3 | 10.7 | 36.1 | 0.11 | 1400 nm |
| 7.0 | 56.3 | 7.3 | 36.4 | 0.07 | 1600 nm |

| | | | | | |
|---|---|---|---|---|---|
| * Total content of Ag, Au, and Te in compound constituting nanoparticle was 100%. | | | | | |

Referring to Fig. 5 and Table 3, the samples at ratios of Ag loaded of 7.0, 4.7, and 3.0 exhibit particularly long absorption edge wavelengths. The nanoparticle at a ratio of Ag loaded of 0.33, although also has responsivity on a long-wavelength side of 1000 nm or more, exhibits a short absorption edge wavelength as compared with the nanoparticles at ratios of Ag loaded of 7.0, 4.7, and 3.0. This nanoparticle includes no Au. It is then determined also in consideration of the above TEM observation results that AgAuTe semiconductor nanoparticles each having favorable dispersibility, being capable of keeping a single particle state and having favorable responsivity in a long-wavelength region are those at ratios of Ag loaded of 4.7 (the proportion of the number of Au atom: 0.107) and 3.0 (the proportion of the number of Au atom: 0.156). These AgAuTe semiconductor nanoparticles are expected to exhibit particularly effective responsivity in both the near infrared region (NIR) and the short-wave infrared region (SWIR).

Third Embodiment: In the present Embodiment, AgAuTe nanoparticles were each synthesized at the heating temperature (reaction temperature) varied, in a reaction system formed from a metal source precursor and a Te precursor mixed. The metal source precursor (at a ratio of Ag loaded of 3.0) was prepared with the same Ag precursor and Au precursor as those in Second Embodiment, and mixed with the Te precursor (Te 0.2 mmol) to form the reaction system. The heating temperature was set to 50°C and 70°C to allow the reaction to occur, thereby synthesizing each semiconductor nanoparticle. The same operation as in Second Embodiment was performed except for the reaction temperature.

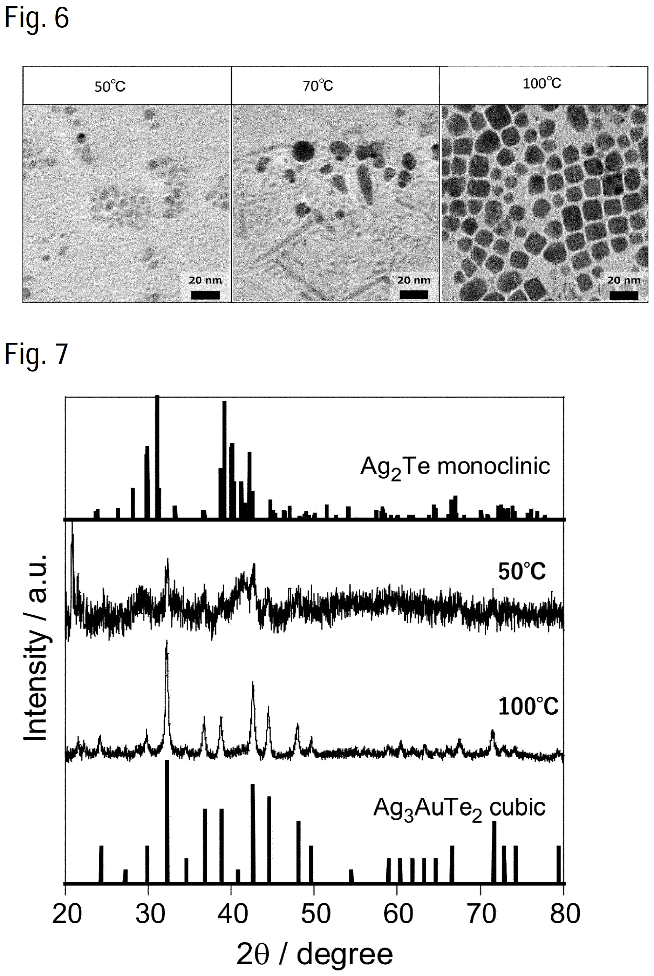

Fig. 6 illustrates TEM images of the AgAuTe nanoparticles synthesized in the Embodiment. Fig. 6 also illustrates the TEM image of the AgAuTe nanoparticle (at a ratio of Ag loaded of 3.0 and a reaction temperature of 100°C) synthesized in Second Embodiment. The sample at a reaction temperature of 50°C is a microparticle weak in contrast. The reaction temperature is raised to high temperatures of 70°C and 100°C to allow the contrast of each particle to be clearer. Table 4 shows the compositional analysis results by EDX analysis simultaneously performed with TEM observation).

**[Table 4]**

| Reaction temperature | Amount loaded (mmol) | | | Composition (% by atom) | | | y/(x + y + z) | z/(x + y + z) |
|---|---|---|---|---|---|---|---|---|
| | Ag(OAc) | HAuCl₄ | TeO₂ | Ag | Au | Te | | |
| 50°C | | | | 50.2 | 15.8 | 34.1 | 0.158 | 0.341 |
| 70°C | 0.3 | 0.1 | 0.2 | 50.0 | 15.6 | 34.3 | 0.156 | 0.343 |
| 100°C | | | | 49.3 | 15.6 | 35.1 | 0.156 | 0.351 |

| | | | | | | | | |
|---|---|---|---|---|---|---|---|---|
| * Total content of Ag, Au, and Te in compound constituting nanoparticle was 100%. | | | | | | | | |

It can be seen from Table 4 that the AgAuTe nanoparticles synthesized in the present Embodiment do not largely differ in composition. The reaction temperature is considered not to have a large effect on the compositions of the AgAuTe nanoparticles.

Fig. 7 illustrates XRD diffraction patterns of the AgAuTe nanoparticles synthesized in the present Embodiment. XRD analysis conditions are the same as those in Second Embodiment. Fig. 7 also illustrates the diffraction pattern of the AgAuTe nanoparticle (at a ratio of Ag loaded of 3.0 and a reaction temperature of 100°C) synthesized in Second Embodiment. Each of the samples exhibits a diffraction pattern identifiable as Ag₃AuTe₂. However, it can be seen that the sample at a reaction temperature of 50°C exhibits a broad peak and is low in crystallinity as compared with the sample at a reaction temperature of 100°C. It has been confirmed in consideration of the above TEM observation results that a higher reaction temperature results in higher crystallinity.

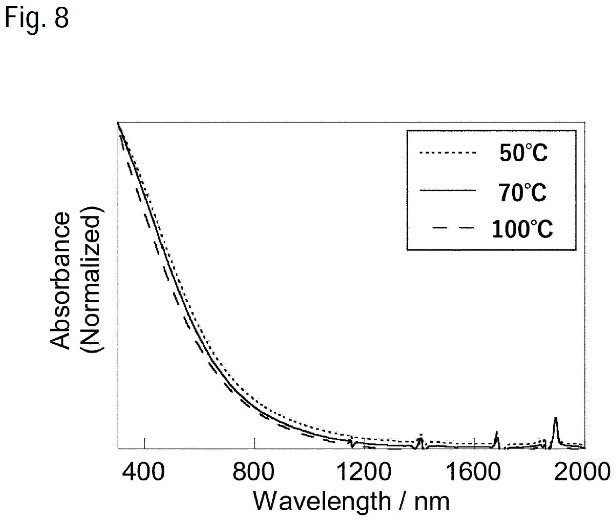

Fig. 8 illustrates measurement results of absorption spectra of the AgAuTe nanoparticles synthesized in the present Embodiment. As clear from Fig. 8, the AgAuTe nanoparticles synthesized in the present Embodiment did not differ in absorption spectrum, and each of the nanoparticles exhibited an absorption edge wavelength near 1400 nm. It is deemed from the above compositional analysis results that the AgAuTe nanoparticles less differ in composition due to the reaction temperature. It is deemed that these nanoparticles less differ also in absorption characteristics due to the reaction temperature.

### INDUSTRIAL APPLICABILITY

As described above, the semiconductor nanoparticle including a AgAuTe compound of the present invention can exhibit favorable optical semiconductor characteristics. This AgAuTe compound is provided also in consideration of correspondence to use restrictions and avoidance of use of heavy metals. The semiconductor nanoparticle of the present invention is expected to be applied in a light-emitting device or a fluorescent substance utilized in a display apparatus, a marker substance for bio-related substance detection, or the like, or a photoelectric conversion device or a light-receiving element mounted in a solar battery, a light sensor, or the like. In particular, the present invention has achieved improvements in light absorption characteristics in a long-wavelength region including the near infrared region (NIR) and the short-wave infrared region (SWIR). The present invention is thus particularly useful for a light-receiving device applicable in LIDAR and SWIR image sensors where responsivity in the near-infrared region is important, among photonic devices described above.

## Claims

1. A semiconductor nanoparticle comprising a AgAuTe compound containing Ag, Au, and Te as essential constituent elements, represented by the following formula, wherein the semiconductor nanoparticle comprises 90% by atom or more of the AgAuTe compound:
[Formula 1] AgₓAu_{y}Te_{z}
wherein x, y, and z are the respective numbers of Ag, Au, and Te atoms, and 0.25 ≤ z/(x + y) ≤ 1 and y/(x + y + z) > 0.10 are satisfied.

2. The semiconductor nanoparticle according to claim 1, wherein 0.1 ≤ x/(x + y + z) ≤ 0.6 is satisfied in the AgAuTe compound.

3. The semiconductor nanoparticle according to claim 1 or claim 2, wherein the semiconductor nanoparticle comprises 99% by atom or more of the AgAuTe compound.

4. The semiconductor nanoparticle according to claim 1 or claim 2, wherein the semiconductor nanoparticle has a spherical shape or a cube shape, and has an average particle size of 2 nm or more and 20 nm or less.

5. The semiconductor nanoparticle according to claim 1 or claim 2, wherein the AgAuTe compound comprises
a core compound comprising a Au-rich AgAuTe compound, and
a shell compound that covers at least one portion of a surface of the core compound and that comprises a Ag- and Te-rich AgAuTe compound.

6. The semiconductor nanoparticle according to claim 1 or claim 2, wherein at least any one of an alkylamine having 4 or more and 20 or less alkyl chain carbon atoms, an alkenylamine having 4 or more and 20 or less alkenyl chain carbon atoms, an alkylcarboxylic acid having 3 or more and 20 or less alkyl chain carbon atoms, an alkenylcarboxylic acid having 3 or more and 20 or less alkenyl chain carbon atoms, and an alkanethiol having 4 or more and 20 or less alkyl chain carbon atoms is bound as a protective agent to a surface of the semiconductor nanoparticle.

7. The semiconductor nanoparticle according to claim 1 or claim 2, wherein an absorption edge wavelength on a long-wavelength side of an absorption spectrum is 1200 nm or more.
